# DEMANDE DE BREVET EUROPEEN

(11) **EP 0 991 127 A1**
(43) Date de publication de la demande: **05.04.2000**
(21) Numéro de dépôt: 99402339.8
(22) Date de dépôt: 24.09.1999
(51) Int. Cl.: H01L 27/146, H01L 21/60

(54) **Dispositif hybride et procédé de realisation de composants eléctriquement actifs par assemblage**

(30) Priorité: 28.09.1998 FR 9812072
(71) Demandeur: COMMISSARIAT A L'ENERGIE ATOMIQUE, 75752 Paris Cédex 15 (FR)
(72) Inventeur: Marion, Francois, 38120 Saint Egreve (FR)
(74) Mandataire: Signore, Robert

(57) **Abrégé**

L'invention concerne un procédé d'assemblage d'un premier et d'un second composants électroniques (2,4), le premier des composants étant muni de plots conducteurs (42) de connexion, le procédé comportant :
- une étape d'assemblage des deux composants,
- la réalisation d'au moins une zone électriquement active (40) dans le second composant, par diffusion du matériau des plots de connexion du premier vers le second composant.

## Description

### Domaine technique et art antérieur

La présente invention se rapporte au domaine de l'électronique ainsi qu'au domaine de l'assemblage de deux composants électroniques provenant de sources (de substrats) différents.

Elle se rapporte également à la génération par assemblage de fonctions électriquement actives (de type "diode", par exemple).

Des exemples d'application possible sont celles des détecteurs d'ondes infrarouges, mais d'autres types de composants peuvent être construits avec cette technique (par exemple : détecteurs dans le visible, diodes électroluminescentes, etc.).

Deux familles de dispositifs "hybrides" optoélectroniques par report de couches épitaxiales sont étudiées actuellement, utilisant deux techniques d'assemblage :
- la technique épitaxiale "liftoff" ("ELO")
- la technique d'hybridation par bille ("FLIP-CHIP")

Le brevet français FR-2 715 002 montre comment la technique "FLIP-CHIP" adaptée permet de reporter et d'interconnecter des couches épitaxiées sur un circuit de lecture en silicium.

Ces techniques visent à réaliser l'assemblage de couches épitaxiées à un circuit silicium. Par exemple, une technologie est réalisée sur une tranche de silicium, tandis qu'une technologie est réalisée sur une tranche d'un autre matériau, par exemple AsGa.

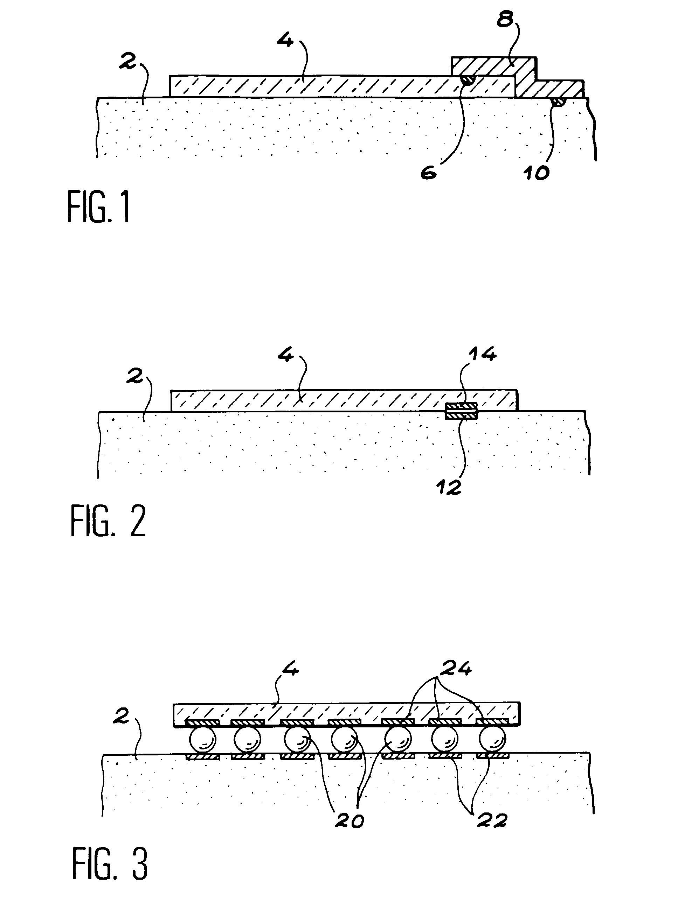

L'épitaxie réalisée sur le substrat AsGa est reportée sur le substrat silicium. L'interconnexion entre ces deux composants est assurée par la mise en contact de métallisations réalisées sur chacun des composants :
- Dans le cas de la technologie "ELO", cette interconnexion électrique est assurée par une technologie complémentaire après assemblage Si. Sur la figure 1, un circuit de lecture 2 en silicium supporte une couche mince épitaxiée 4, en un autre matériau. Les références 6, 10 désignent les contacts en métal. La reprise de contact 8 est faite par la face supérieure de l'épitaxie.

Sur la figure 2, la connexion électrique est assurée par les contacts métalliques 12, 14. Autrement dit, cette connexion est assurée par un contact et un recuit métal-métal sur les faces en regard, si la reprise de contact est par la face en regard du circuit silicium.

Dans le cas de la technologie "FLIP-CHIP", l'interconnexion est assurée par des billes 20 de type étain-plomb ou indium reliant les plots métalliques 22, 24 (figure 3).

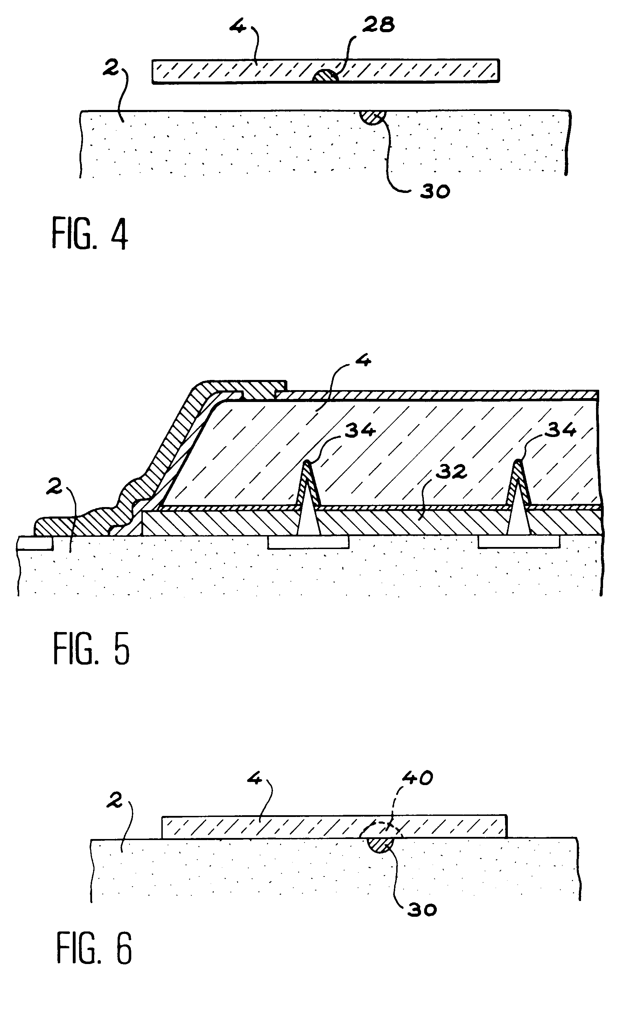

Dans tous les cas de figure, les composants doivent être assemblés avec une extrême précision de telle manière que les technologies présentes sur les composants rapportés coïncident avec les technologies présentes sur les composants receveurs. En particulier, comme illustré sur la figure 4, les écarts dx, dy (suivant deux directions) entre deux contacts métalliques 28, 30, doivent être inférieurs à 5 µm, ou mieux.

Le brevet américain US 5 536 680 propose de réaliser un détecteur infrarouge par création de diodes au moment de l'assemblage. C'est la technologie dite SAB : "Soft Aligned Bonding".

Une couche épitaxiée est mise en regard d'un circuit de silicium 2 recouvert de colle 32 et muni de micropointes 34 (figure 5), une pression est exercée entre les deux circuits 2, 4 et les micropointes créent une zone N dans la matériau P en regard.

Comme déjà mentionné ci-dessus, les deux technologies ELO et FLIP-CHIP nécessitent d'aligner parfaitement les composants lors de l'assemblage, les spécifications requises en général sont des précisions meilleures que +/-5 µm et même atteignent +/-1 µm. Cette opération d'assemblage nécessite des équipements coûteux.

La technologie SAB est une technique auto-alignée.

Les deux technologies ELO et FLIP-CHIP nécessitent la réalisation des technologies spécifiques à l'assemblage sur les deux composants à assembler :
- Réalisation de métallisation de contact de part et d'autre, dans tous les cas (voir figures 1, 2, 4)
- Réalisation d'une technologie, après assemblage, dans le cas de la technologie ELO (figure 1).
- Réalisation d'une technologie de billes de soudure dans le cas de la technologie FLIP-CHIP.

La technologie SAB ne nécessite pas de technologie côté détecteur. Elle nécessite une technologie côté circuit de lecture (micropointes).

Enfin, les deux technologies ne permettent pas facilement la réalisation de composants de grande taille et/ou de petit pas.

La technologie ELO nécessite la manipulation de couches de quelques micromètres d'épaisseur, donc extensibles. Il est impossible, alors, de garantir un alignement meilleur que le micromètre sur une longueur de plusieurs centimètres.

La technologie FLIP-CHIP nécessite de réaliser, par exemple, la technologie billes dans un pas de 10 µm (ou moins), ce qui implique des variations de planéités induites des composants en regard extrêmement réduites.

D'autre part, pour un pas donné et un nombre de points donnés, les différences des coefficients de dilatation des composants à assembler font qu'il est impossible d'avoir les composants face à face à la température d'hybridation : les zones de contact se croisent à la température d'hybridation et ne sont plus en regard pour la soudure.

On peut prendre l'exemple de la réalisation d'un détecteur infrarouge de 2000 x 2000 points, au pas de 20 µm. Ceci conduit à des tailles de composants de 40 x 40 mm sur la zone de photodétection.

Sur une telle taille, les techniques d'hybridation font que la dilatation thermique entre circuits de détection (par exemple un substrat en CdTe) et de lecture (par exemple en silicium), en bout de diagonale, est de plus de 18 µm à la température d'hybridation, ce qui interdit l'emploi de cette technique pour l'assemblage.

De même, il est impossible d'aligner une couche mince extensible, avec une précision suffisante, sur des composants de cette taille (technologie ELO).

La technologie SAB permet quant à elle de résoudre les problèmes d'alignements et des grandes tailles, mais avec les autres inconvénients suivants :
- Les micropointes doivent toutes avoir la même pression simultanée pour la création de diodes. Ceci implique des planéités extrêmes de composants, et des appareillages complexes pour le parallélisme lors de la mise en pression.
- Cette technique ne convient qu'aux matériaux où une zone de contrainte entraîne la création d'une zone de type opposé de celui où elle est exercée (N sur P ou P sur N).

Ceci est vrai pour les composés de type CdHgTe (CMT) mais pas pour tous les matériaux où une zone de contrainte ne correspond en général pas à la création d'une diode.
- Dans le cas du CdHgTe, on ne sait pas reprendre par cette technique un contact ohmique de type P, la micropointe créant automatiquement une zone de type N.

### Exposé de l'invention

L'invention a pour objet un procédé d'assemblage d'un premier et d'un second composants électroniques, le premier des composants étant muni de plots conducteurs de connexion comprenant au moins un matériau susceptible de diffuser dans le second composant,
le procédé comportant :
- une étape d'assemblage des deux composants, et
- la réalisation d'au moins une zone électriquement active dans le second composant, par diffusion dudit matériau des plots de connexion du premier composant vers le second composant.

La technique selon l'invention permet :
- d'éviter la réalisation d'une opération supplémentaire de diffusion ou d'implantation dans le deuxième composant,
- d'éviter tout problème d'alignement lors de l'assemblage des composants,
- d'éviter les contraintes de planéité (procédé FLIP-CHIP),
- de réaliser des composants de très grande dimension et de très faible pas du fait des non-contraintes de planéité et d'alignement,
- de diminuer les coûts de fabrication de manière radicale,
- de créer toutes sortes de diodes en fonction du choix du matériau des plots de connexion.

En particulier, les plots de connexion peuvent être en un métal dopé, le dopant diffusant dans le second composant.

Ce dopant peut être par exemple de l'indium et/ou de l'arsenic et/ou de l'antimoine et/ou du mercure.

Il est possible de réaliser la zone électriquement active simultanément à l'étape d'assemblage.

Selon un exemple, les premier et second composants peuvent être, respectivement, un circuit de lecture et un circuit de détection infrarouge, par exemple en CdHgTe.

L'invention a également pour objet un dispositif hybride comportant un premier et un second composants assemblés, le premier composant étant muni d'au moins un plot de connexion, conducteur électrique, comprenant au moins un matériau susceptible de diffuser dans le deuxième composant, et le deuxième composant présentant au moins une zone dopée avec ledit matériau, chaque zone dopée étant disposée en face et en contact avec un plot de connexion correspondant.

Le matériau susceptible de diffuser peut être un matériau constituant un dopant dans le deuxième composant.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- La figure 1 représente un dispositif ELO dont la face active est située à l'opposé de la face active d'un circuit de lecture, la couche épitaxiée et le circuit de lecture étant reliés par une technologie post-assemblage.
- La figure 2 représente un dispositif ELO dont la face active est située en regard du circuit de lecture, les technologies réalisées sur la couche et le circuit de lecture étant assemblées en regard.
- La figure 3 représente un dispositif FLIP-CHIP, une couche épitaxiée et un circuit de lecture étant liés par l'intermédiaire de billes de soudure.
- La figure 4 montre les désalignements dx, dy introduits par assemblage entre deux composants assemblés.
- La figure 5 montre un dispositif SAB
- La figure 6 représente un dispositif selon l'invention.
- Les figures 7A à 7C représentent des étapes d'un procédé selon l'invention.
- La figure 7D illustre une variante de mise en oeuvre de l'invention.
- Les figures 8A et 8B représentent des étapes d'assemblage dans le cadre d'un procédé selon l'invention.
- La figure 9 illustre une variante d'un procédé selon l'invention.

### Description détaillée de modes de réalisation de l'invention

La figure 6 représente un assemblage réalisé selon l'invention, d'un substrat en silicium comprenant un circuit de lecture et d'une couche mince 4 épitaxiale.

Dans la suite du texte, le substrat comprenant le circuit de lecture est simplement désigné par "circuit de lecture 2".

On entend par couche épitaxiale une couche qui a été initialement formée par épitaxie sur un autre substrat et qui a été rapportée sur le circuit 2. Une zone active 40 est créée dans la couche 4 lors de l'assemblage, par diffusion induite du matériau d'un plot métallique 30 du circuit de lecture 2.

La zone 40 de la couche mince rapportée à été créée pendant l'assemblage de la couche mince et du circuit de lecture. Cette zone est électriquement active : dans le cas d'un détecteur de radiation, la zone peut être une diode (détecteur photovoltaïque) ou un contact (détecteur photoconducteur).

Une multitude de zones, du type de la zone 40, peut être présente sur un circuit assemblé, toutes étant générées pendant l'assemblage.

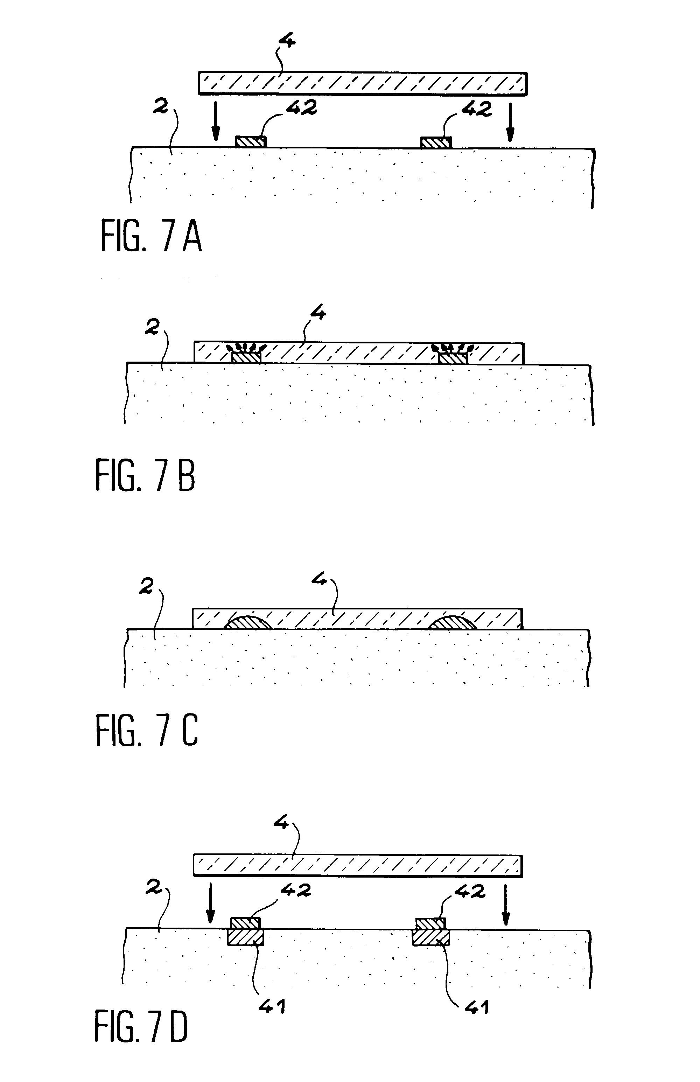

Les figures 7A à 7C montrent le principe général de réalisation d'un dispositif selon l'invention.

Les figures 7A à 7C montrent le report d'une couche mince 4 (appelée couche épitaxiale) sur la surface d'un substrat 2 incluant le circuit de lecture. La surface du substrat a été préalablement polie pour permettre une bonne adhérence de la couche mince. On observe que des plots conducteurs 42 comprenant au moins un matériau dopant susceptible de diffuser dans la couche mince, sont également formés à la surface du circuit de lecture.

Lors de l'assemblage, la couche épitaxiale adhère sur le substrat du circuit de lecture, par des forces de Van der Waals. Après dépôt de la couche, un recuit permet de faire diffuser le dopant dans la couche épitaxiale et créer (par exemple) une diode en regard de chaque plot de connexion. La diode créée est auto-alignée avec la zone en regard du circuit de lecture.

La figure 7D correspond à une variante perfectionnée du procédé. Pour éviter la diffusion du dopant à l'intérieur du circuit de lecture, on intercale une couche de barrière de diffusion 41 (par exemple en platine) entre les plots de connexion et le circuit de lecture.

Un procédé de réalisation d'un détecteur infrarouge de grande taille (2000 x 2000 points, avec un pas de 20 µm) peut donc être le suivant :
- on réalise une couche épitaxiale 4, de grande taille, sur un substrat (CdTe, par exemple),
- on réalise un circuit de lecture 2 muni de plots d'indium 42, au pas voulu (ici : 20 µm),
- on dépose sous vide la couche épitaxiale sur le circuit de lecture (sans précautions spécifiques d'alignement : figure 7A),
- on fait diffuser les plots d'indium 42 dans la couche épitaxiale 4, (figure 7B), de manière à obtenir un réseau de diode (figure 7C).

Les plots d'indium 42 sont de préférence réalisés avec une très faible épaisseur (210 nm) afin de ne pas perturber l'adhésion par les forces de Van der Waals. De plus, grâce à leur faible épaisseur, les plots constituent des sources de diffusion limitées en volume.

Un mode de réalisation d'un détecteur infrarouge conforme à l'invention, va être décrit.

Tout d'abord, le circuit de lecture peut être réalisé dans les filières classiques (par exemple CMOS). Une finition spécifique permet de réaliser :
- un poli optique de finition pour l'assemblage,
- les plots de diffusion pour le dopage de la couche épitaxiée.

Une méthode de réalisation de ce circuit peut être la suivante :
- dépôt d'une couche de platine et photogravure (sur les lieux des pixels de photodétection) : cette couche sert de barrière, côté circuit de lecture, au dopant déposé ultérieurement. Les plots de platine sont situés au-dessus des reprises de contact ménagées dans le circuit de lecture,
- dépôt d'une couche épaisse d'oxyde (pour planarisation),
- polissage d'aplanissement jusqu'à effleurement du platine (type chemical mechanical polishing "CMP", classique dans l'industrie du semi-conducteur),
- dépôt par lift-off d'une couche d'indium de quelques angströms, par exemple 100 Å sur un carré de 2 x 2 µm, au-dessus des zones platinées.

En ce qui concerne la réalisation du circuit de détection infrarouge par épitaxie, on pourra par exemple réaliser des couches de grandes tailles par deux techniques (épitaxie en phase liquide ou épitaxie par jet moléculaire) sur différents types de substrats (CdZnTe, silicium, ....). On peut pour cela se reporter par exemple au brevet US 4 056 304.

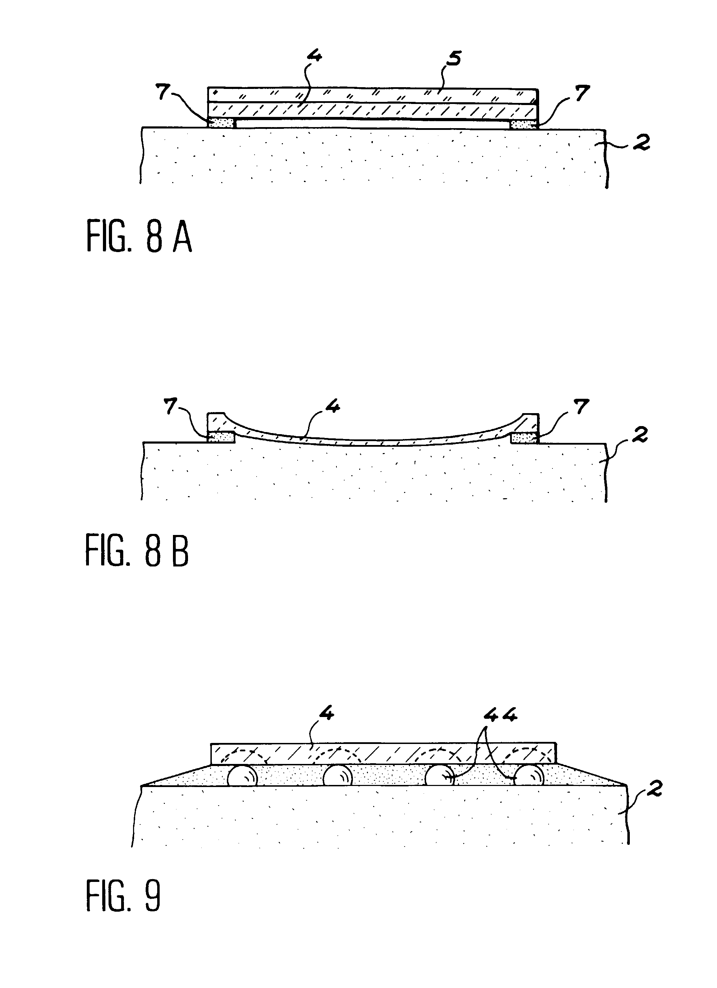

En ce qui concerne l'assemblage, on pourra, par exemple, procéder de manière analogue à la technique FLIP-CHIP, en collant sous vide, à l'aide d'une résine 7, la couche 4 sur sa périphérie sur le substrat 5 (face contre le silicium de lecture, figure 8A), et en attaquant chimiquement le substrat support 5 (figure 8B).

On peut éventuellement passiver la surface mise à nu de CdHgTe.

On peut également faire diffuser l'indium en contact avec le CdHgTe (sous atmosphère Hg éventuellement).

L'indium est un dopant de type N pour le CdHgTe : de quelques minutes à quelques heures à des températures basses (120°C à 300°C) permettent d'obtenir une jonction de type N sur CdHgTe de quelques µm de profondeur en regard de chaque plot d'indium 42 déposé sur le silicium. Cette jonction sera liée au silicium de lecture par l'intermédiaire des plots platine 41.

Si l'on désire reprendre directement le contact substrat de type P on réalisera le dépôt de deux types de dopant sur le circuit de lecture, de type N et de type P (arsenic, antimoine).

Une variante intéressante de l'invention est une combinaison des techniques " FLIP-CHIP" et de la technique ci-dessus. Cette variante est décrite par le dispositif présenté sur la figure 9.

Son mode de réalisation est le suivant, dans le cas d'un détecteur infrarouge :
- hybridation de la couche 4 de CMT, encore liée à son substrat, sur le circuit de lecture 2 (l'indium se soude sur le CdHgTe),
- enrobage par exemple par la technique ERAM décrite dans le document FR 2 715 002. La référence 46 désigne ainsi une résine d'enrobage.
- diffusion de l'indium des billes 44 dans la couche épitaxiale, formant ainsi une zone N sur P,
- amincissement, par exemple décrit tel que dans le document FR-2 715 002 également.

Cette technique est intéressante, car elle utilise des technologies bien éprouvées par ailleurs, et elle permet une manipulation de la couche sur son substrat.

L'invention peut s'appliquer à la réalisation de :
- rétines de diodes émettrices,
- rétines de détection photoconductrices ou photovoltaïques de très grandes tailles pour la détection dans tous les domaines spectraux, ou de matrices de diodes,
- rétines de détection de faible coût et de toutes tailles.

L'invention s'applique également à toutes les autres applications, où la diffusion d'une diode ou d'un contact ohmique par source solide localisée permet de créer un composant actif lors de l'assemblage de deux composants face contre face.

## Revendications

1. Procédé d'assemblage d'un premier et d'un second composants électroniques (2,4), le premier des composants étant muni de plots conducteurs (42, 44) de connexion comprenant au moins un matériau susceptible de diffuser dans le second composant,
le procédé comportant :
- une étape d'assemblage des deux composants, et
- la réalisation d'au moins une zone électriquement active (40) dans le second composant, par diffusion dudit matériau des plots de connexion (42) du premier composant vers le second composant.

2. Procédé selon la revendication 1, dans lequel la zone électriquement active est réalisée simultanément à l'étape d'assemblage.

3. Procédé d'assemblage selon l'une des revendications 1 ou 2, dans lequel l'étape d'assemblage est réalisée par hybridation du second composant sur le premier à l'aide de billes métalliques (44), lesdites billes constituant les plots conducteurs.

4. Procédé selon la revendication 3, dans lequel la réalisation de la zone électriquement active est suivie d'une étape d'enrobage du deuxième composant par une résine.

5. Procédé selon l'une des revendications 1 à 4, dans lequel le premier composant (2) comprend un circuit de lecture.

6. Procédé selon des revendications 1 à 5, dans lequel le second composant comprend un circuit de détection.

7. Procédé selon la revendication 6, dans lequel le circuit de détection est un circuit en CdHgTe.

8. Procédé selon l'une des revendications précédentes, dans lequel le matériau (42) des plots de connexion comprend un matériau dopant du second composant.

9. Procédé selon la revendication 8, dans lequel le matériau (42) des plots de connexion comprend de l'indium et/ou de l'arsenic et/ou de l'antimoine et/ou du mercure.

10. Procédé selon l'une des revendications 1 à 5, dans lequel le second composant est une couche formée par épitaxie sur un substrat CdTe.

11. Dispositif hybride comportant un premier et un second composants assemblés, le premier composant étant muni d'au moins un plot de connexion (42, 44), conducteur électrique, comprenant au moins un matériau susceptible de diffuser dans le deuxième composant, et le deuxième composant présentant au moins une zone dopée avec ledit matériau, chaque zone dopée étant disposée en face et en contact avec un plot de connexion correspondant.

12. Dispositif selon la revendication 11, dans lequel le premier composant comporte un circuit de lecture.

13. Dispositif selon la revendication 12, dans lequel le second composant comprend un circuit de détection.

14. Dispositif selon la revendication 13, dans lequel le circuit de détection est en CdHgTe.

15. Dispositif selon la revendication 11, dans lequel le matériau des plots conducteurs (42) de connexion comporte de l'indium et/ou de l'arsenic, et/ou de l'antimoine et/ou du mercure.

16. Dispositif selon la revendication 11, dans lequel les plots de connexion (42) comportent des billes métalliques (44).

17. Dispositif selon la revendication 11, dans lequel le premier composant comporte au moins une couche (41) de barrière de diffusion supportant au moins un plot de connexion (42).
